Europäisches Patentamt

European Patent Office

Office européen des brevets

(19)

(11) Veröffentlichungsnummer : **0 471 698 B1**

(12) **EUROPÄISCHE PATENTSCHRIFT**

(45) Veröffentlichungstag der Patentschrift :
15.09.93 Patentblatt 93/37

(51) Int. Cl.$^5$ : **G01R 31/36**

(21) Anmeldenummer : **90906876.9**

(22) Anmeldetag : **08.05.90**

(86) Internationale Anmeldenummer :
**PCT/DE90/00322**

(87) Internationale Veröffentlichungsnummer :
**WO 90/13823 15.11.90 Gazette 90/26**

(54) **VERFAHREN ZUR BESTIMMUNG VON PHYSIKALISCHEN GRÖSSEN VON WIEDERAUFLADBAREN ELEKTRISCHEN ENERGIESPEICHERN.**

(30) Priorität : **12.05.89 DE 3915550**

(43) Veröffentlichungstag der Anmeldung :
**26.02.92 Patentblatt 92/09**

(45) Bekanntmachung des Hinweises auf die
Patenterteilung :
**15.09.93 Patentblatt 93/37**

(84) Benannte Vertragsstaaten :
**AT BE CH DE DK ES FR GB IT LI LU NL SE**

(56) Entgegenhaltungen :
EP-A- 0 225 106
DE-A- 3 429 145
DE-A- 3 736 481
US-A- 4 333 149
US-A- 4 390 841
US-A- 4 455 523
US-A- 4 743 831

(73) Patentinhaber :
**FRAUNHOFER-GESELLSCHAFT ZUR
FÖRDERUNG DER ANGEWANDTEN
FORSCHUNG E.V.
Leonrodstrasse 54
D-80636 München 19 (DE)**

(72) Erfinder : **BIRKLE, Michael
Am Kirchberg 41
D-7500 Karlsruhe 41 (DE)**
Erfinder : **GRASEMANN, Gunther
Links der Alb 22
D-7500 Karlsruhe 51 (DE)**
Erfinder : **STEUSLOFF, Hartwig
Kirchfeldstrasse 60
D-7500 Karlsruhe 31 (DE)**

EP 0 471 698 B1

Jouve, 18, rue Saint-Denis, 75001 PARIS

**Beschreibung**

1. Anwendungsgebiet

Die Erfindung betrifft eine Verfahren zur Bestimmung des Ladungszustandes und weiterer physikalischer Größen wie Verschleißzustand, Alter, Exemplarstreuung, Vorgeschichte und Ladewirkungsgrad eines wiederaufladbaren elektrischen Energiespeichers gemäß dem Oberbegriff des Anspruch 1, wie es beispielsweise aus US-PS 4390841 bekannt ist.

Wiederaufladbare (reversible) Energiespeicher werden heute in sehr vielen Bereichen eingesetzt, um den Betrieb von elektrischen Geräten netzunabhängig zu gewährleisten. Die gegenwärtig am meisten verbreiteten Typen sind Blei-Akkus, Nickel-Cadmium-Akkus, Natrium-Schwefel-Akkus und Lithium-Fluor-Akkus. Neben vielen Vorteilen, die damit verbunden sind, bringt ihr Einsatz auch Probleme mit sich, z.B. die höheren Kosten und den Wartungsaufwand, hauptsächlich aber den begrenzten Energievorrat. Nun ist aber die Tatsache, daß die entnehmbare Energie endlich ist und der verwendete Akku irgendwann ausgetauscht oder wieder aufgeladen werden muß, als solche durchaus zu verschmerzen. Die eigentliche Schwierigkeit besteht darin, daß man oft nicht weiß, wann dies sein wird, d.h. wie lange man sein Gerät mit dem aktuell verwendeten Akku noch betreiben kann bzw. wieviel Energie/Ladung sich noch im Akku befindet.

In einigen Anwendungsbereichen sind diese Einschränkungen nur ärgerlich oder teuer; in vielen Fällen führen sie aber auch dazu, daß ganz auf den Einsatz von Akkus verzichtet wird. Es werden dann meistens die nicht reversiblen umweltbelastenden Primärzellen eingesetzt, die ab einem gewissen Verbrauch (Zyklenzahl) teurer und extrem umweltbelastend sind, aber hinsichtlich der Ladungsinformation weniger Probleme aufweisen, da sich die fortgeschrittene Entladung rechtzeitig durch einen Spannungsrückgang bemerkbar macht. Die sicherheitsrelevanten Bereiche wie Medizin, Verkehr, Feuerwehr etc. sind an erster Stelle zu nennen, aber auch viele Hobby-Anwendungen (z.B. Tauchen, Bergsteigen, Modellbau) öffnen sich dem Akkueinsatz nur langsam oder bisher noch gar nicht.

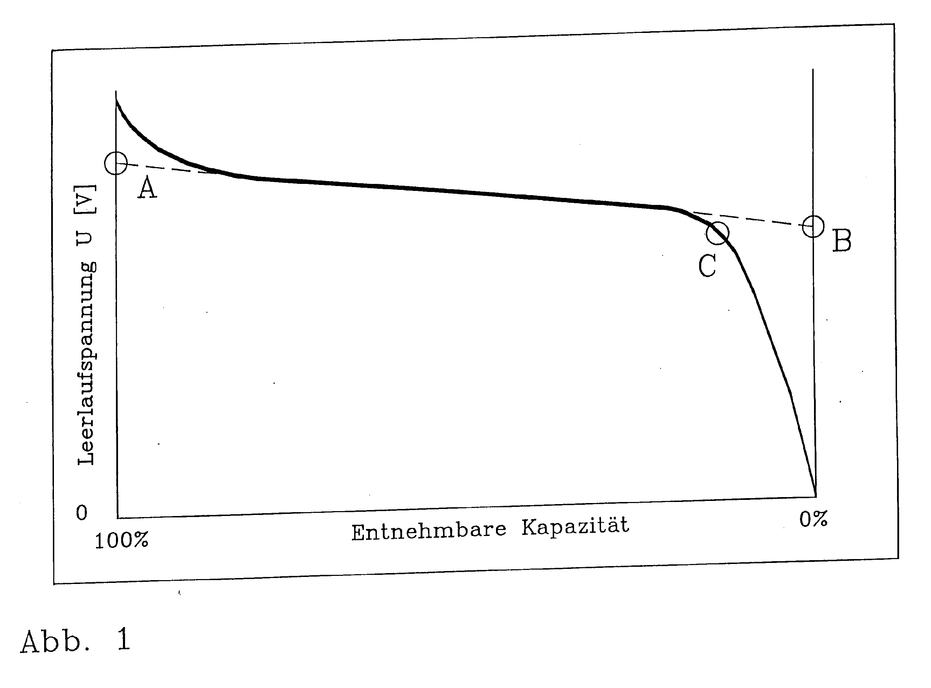

Der Grund dafür liegt in dem Verhalten der meisten aufladbaren Batterien, wie es in Abb. 1 am Beispiel des weit verbreiteten NiCd-Akkus dargestellt ist:

Vor dem plötzlichen und steilen Spannungsabfall kurz vor der völligen Entladung ist eine lange Phase mit nahezu konstanter Spannung zu erkennen; während ca. 90% der Entladedauer (bei konstantem Strom) ändert sich die Spannung nur um weniger als 10%. Diese Eigenschaft ist zunächst eine günstige Voraussetzung, denn eine nahezu konstante Spannung während fast der gesamten Betriebsdauer des Akkus sorgt in dieser Zeit für die volle Leistungsfähigkeit des Geräts. Auf der anderen Seite wird aber der Punkt C in der dargestellten Entladekurve, nämlich die Stelle, an der spätestens eine erneute Aufladung erfolgen muß, erst zu einem Zeitpunkt erkennbar, an dem nur noch wesentlich weniger als 10% der Gesamtladung verfügbar sind und die Spannungsversorgung danach sehr bald völlig zusammenbricht.

Die einzigen ohne Eingriffe in den Akku meßbaren Größen sind Stromstärke und Temperatur, die durch die Umgebung vorgegeben werden, und die Spannung, die sich bei diesen Bedingungen an den Elektroden des Akkus einstellt. Die Nennspannung eines Akkus ist abhängig vom Alter und von Eigenschaften des Akkus, die der Exemplarstreuung unterliegen. Da sich die Spannungsänderung im Hauptteil des Entladevorgangs in derselben Größenordnung wie die erwähnte Streuung der Nennspannung bewegt, kann die Spannung allein nur ein sehr schlechtes Maß für den Ladungs-/Energie-Inhalt des Akkus darstellen. Für die Bestimmung des Ladezustands sind deshalb Systeme notwendig, die aus den meßbaren Größen die dafür erforderlichen Informationen ableiten.

2. Stand der Technik; Aufgabe der Erfindung

Bei den bislang bekannten Verfahren der Ladezustandsüberwachung werden die leicht meßbaren Größen des Prozesses erfaßt (I , T, U, t), die Be-/Entladung von Beginn des Prozesses an bilanziert und mit Hilfe von physikalischen Formeln für die Abschätzung des Ladungszustandes herangezogen (DE-PS 34 29 145).

Aus der US-Patentschrift 4390841 ist es weiterhin bekannt, daß der Ladungszustand bzw. die verbleibende Restladung indirekt über einen Modellansatz (auch Beobachtungsansatz) bestimmt wird. (Das Messer. mit Beobachtung wird später beschrieben.) Aus dieser Literaturstelle ist jedoch nur bekannt, ein geschlossenes, lineares Modell des Prozesses einzusetzen, wie die Peukert-Gleichung, die jedoch nur für Blei-Akkumulatoren und vergleichbare Typen verwendet werden kann.

Keines der bekannten Verfahren hat sich für die Verwendung im praktischen Einsatz durchsetzen können. Die Gründe dafür liegen in der nicht zufriedenstellenden Meßgenauigkeit der für einen sinnvollen Einsatz zinzuhaltenden Randbedingungen:

- Der Ladezustandsüberwachungsvorgang muß bei den bekannten Verfahren/ Geräten mit einer neuen Batterie gestartet werden; mit bereits gebrauchten brauchten Batterien ist dies bisher nicht möglich. Insbesondere bei Nickel-Cadmium-Zellen kommt es häufig vor, daß Batterien mit unbekannter Vorgeschichte eingesetzt werden. Eine Überwachung geht hier in fast allen Fällen vom falschen Ausgangsdaten aus, die Bestimmung der verfügbaren Kapazität muß deshalb falsch sein.

- Während der Lebensdauer der Batterie darf die Spannung nicht auf Null gehen, da sonst die Überwachungseinheit ihr Gedächnis verliert und nach erneuter Aufladung fälschlicherweise wieder von einer neuen Batterie ausgeht.

- Doch auch bei vollständiger Einhaltung der erforderlichen Rahmenbedingungen ist noch eine keine zufriedenstellende Meßgenauigkeit gewährleistet. Es wird nämlich für die indirekte Bestimmung des Ladezustandes aus den leicht meßbaren Größen von tabellarisch vorliegenden Abhängigkeiten ausgegangen. Hierbei werden jedoch weder die individuellen Fertigungstoleranzen noch hersteller- und typspezifische Unterschiede berücksichtigt.

Aufgabe der Erfindung ist es daher, das Verfahren gem. dem Oberbegriff des Anspruchs 1 dahingehend zu verbessern, daß auch bei Energiespeichern mit unbekanntem Ladezustand, Vorgeschichte, Verschleißzustand, Alter usw. eine zuverlässige Aussage über die verfügbare Kapazität und den voraussichtlichen Wirkungsgrad ermöglicht wird.

Diese Aufgabe wird erfindungsgemäß durch das Verfahren nach Anspruch 1 gelöst. Vorteilhafte Ausgestaltungen des Verfahrens sind in den Unteransprüchen gekennzeichnet.

Eine Einführung zu dem Prinzip des Messens mit Beobachter ist aus IEEE Transactions on Automatic Control vol. AC-16 No 6 Dec.71,Seite 596 - 602, "Introduction to Observers" von David G. Luenberger, bekannt oder aus IEEE Transactions on Military, Electronics Vol. 7, 1963, David Luenberger: "Observing the State of a Linear System", Seite 74 - 80, Prof. Zeitz Michael, Bochum, "Nichtlineare Beobachter...", VDI-Verlag, Fortschrittberichte VDIZ, Reihe 8, Nr. 27.

Das indirekte Messen mit Modellen liefert Ergebnisgrößen, die direkt nicht meßbar sind. Der Vergleich dieser Größen mit den realen Werten des Prozesses ist allenfalls zu einem späteren Zeitpunkt (z.B. beim Erreichen der völligen Entladung) möglich. Vorher aber können nicht erfaßte Einflüsse den Prozeß verändern, sodaß ein zunächst nicht erkennbarer Meßfehler bei der indirekt gemessenen Größe entsteht.

Mißt man etwa an den Elektroden eine Spannung im zentralen Arbeitsbereich des Akkus, so sind daraus - auch nicht bei der Kenntnis eines geschlossenen Modells - kaum Aussagen über den Ladezustand des Akkus ableitbar, wenn man es mit Akkuklassen zu tun hat, die eine flach verlaufende Kennlinie der Spannung aufweisen.

Erst bei Kenntnis zweier wesentlicher Eigenschaften ist die Spannung ein signifikantes Merkmal für den Ladezustand; dies sind die Individualstreuung und der Alterungszustand. Die hierdurch bedingten Änderungen der Spannung liegen in derselben Größenordnung wie diejenigen, die sich aus der Änderung des Ladezustands ergeben.

Eine indirekte Messung z.B. nach DE-OS 3736481 geht von einem neuen Akku bzw. von einem Akku bekannten Alters sowie von den Katalogwerten für den individuellen Energiespeicher aus. Individuelle Abweichungen von den Katalogwerten werden genausowenig berücksichtigt wie Abweichungen des angenommenen Alters vom tatsächlichen Verschleißzustand.

Das Ergebnis ist eine Aussage über den Ladezustand des Akkus, die im Extremfall sehr stark von der Realität abweicht, ohne daß dem Meßsystem über diese Abweichung eine Rückmeldung gegeben wird.

Dieser Effekt wird mit dem erfindungsgemäßen Verfahren vermieden. Im folgenden soll nun die Erfindung näher erläutert werden.

## 3. Darstellung der Erfindung

### 3.1. Messen und Beobachter

Parallel zum Be-/Entladevorgang (Prozeß) läuft eine modellgestützte Simulation, der dieselben Prozeßeingangsgrößen wie dem Prozeß zugeführt werden. Die leicht meßbaren Prozeßausgangsgrößen , in diesem Fall die Spannung U(t), werden mit den korrespondierenden Werten aus dem Modell verglichen. Anschließend werden die aktuellen Modellparameter im Sinne einer Minimierung der Abweichung zwischen realen und modellierten Prozeßausgangsgrößen angepaßt. Dies führt zu folgenden vorteilhaften Eigenschaften des Meßsystems, das im folgenden auch Monitor genannt wird:

a) Es findet durch das ständige Durchlaufen des Beobachterzyklus immer eine Selbstadaption des Systems statt, die allen hersteller-, typ- und akkuspezifischen Streuungen Rechnung trägt.

b) Es können Akkus mit unbekannter Vorgeschichte eingesetzt werden, wobei die bekannten Typdaten als Startwerte bei der Adaption dienen.

c) Nach einem Datenverlust durch Spannungsnulldurchgang kann das System einen neuen Ansatz machen.

d) Die Anpassung erfolgt automatisch an die aktuelle Kennlinie des Akkumulators. Alle Einflüsse durch die inneren und äußeren Prozeßbedingungen werden berücksichtigt.

e) Der Beobachter beginnt mit vorgegebenen Werten, z.B. Katalog- oder Literaturwerten, als Modell 0-ter Ordnung. Mit jedem Adaptionszyklus verbessern sich die aktuellen Modellparameter.

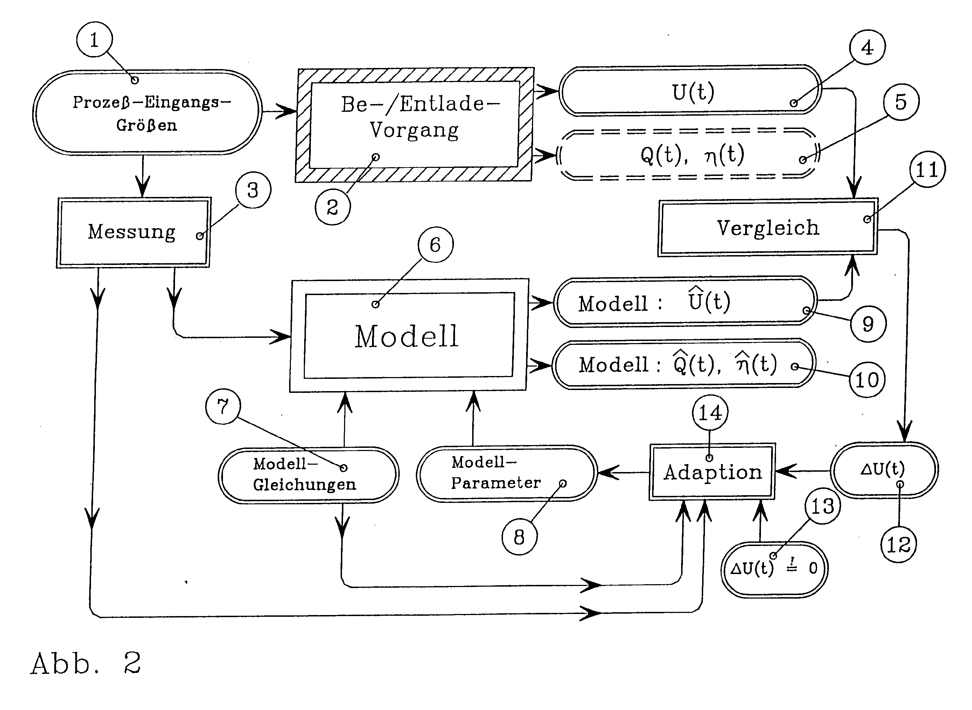

In Abb. 2 ist der auf das Beobachterprinzip basierende Adaptionszyklus dargestellt:

Die leicht meßbaren Prozeß-Eingangs-Größen (1), die Stromstärke, die Zeit, die Temperatur des Akkus und die der Umgebung, beeinflussen den realen Prozeß der Be- oder Entladung (2) und werden gleichzeitig vom Überwachungssystem gemessen (3).

Am Prozeß stellen sich jetzt zu jedem Zeitpunkt seine Ausgangsgrößen ein, von denen ein Teil gemessen werden kann, in diesem Fall die Spannung U(t) (4), ein Teil aber der direkten Messung verborgen bleibt (5). Dies sind im wesentlichen die entnehmbare Ladungsmenge (Q(t) und der differentielle Ladewirkungsgrad $\eta_L$(t).

Parallel zum realen Prozeß wird eine Modell-Rechnung durchgeführt (6), bei der die aus der Messung stammenden Prozeß-Eingangs-Größen an Hand von Modellgleichungen (7) und den dazugehörigen Modellparametern (8) des aktuellen Prozeßzustands zur Berechnung der den Prozeß-Ausgangs-Größen entsprechenden Modell-Ausgangs-Größen $\hat{U}$(f)(9) und $\hat{Q}$(t) und $\eta_L$ (t) (10) verwendet werden.

Die den nicht meßbaren Prozeß-Ausgangs-Größen entsprechenden Modell-Ausgangs-Größen (10) können nicht mit ihren korrespondierenden Größen verglichen werden. Dies geschieht nur mit dem der Spannung entsprechenden Modellausgangswert.

Bei einem deterministischen, geschlossenen Modell ist die Übereinstimmung der beiden Spannungswerte zu einer Übereinstimmung der übrigen Größen dann äquivalent, wenn alle Parameter in den Modellgleichungen für die Spannung vorkommen. Es reicht dann aus, die Abweichung der beiden Spannungswerte (11) zu minimieren, um bei den in (10) angegebenen Größen ein korrektes Abbild des Prozesses vorzufinden.

Zu diesem Zweck wird aus der Spannungsdifferenz (12) zusammen mit den Messwerten aus (3) und den Modell-Eigenschaften (Gleichungen und Parameter, (7) und (8)) im Sinne einer Minimierung der Spannungsdifferenz (13) der Satz der Modellparameter neu berechnet und somit an den aktuellen Prozeß-Zustand adaptiert (14).

Anschließend wird die Modellrechnung (6) mit den neuen Parametern erneut durchgeführt. Die dabei errechneten Größen (10) sind dann das Ergebnis der indirekten Messung.

## 3.2. Heuristische Parameteranpassung

Dem beschriebenen Beobachterzyklus müssen Modelle in Form geschlossener Funktionen, wie z.B. Gleichungen nach dem Peukert-Typ oder aber mehrparametrige Funktionen zu Grunde liegen. Diese Funktionen können linear oder nichtlinear sein.

Je mehr geschlossen angebbare Modellgleichungen das System beschreiben, umso kleiner wird die Menge der möglichen Lösungsvektoren.

Eine eindeutige Lösung der Adaption existiert nur dann, wenn die Modellfunktionen gerade soviele offene Parameter enthalten, wie in die Modellgleichungen eingehende Prozeßgrößen direkt gemessen werden können.

In der Praxis ist es aber meistens so, daß ein System unterbestimmt ist und es stets Klassen von möglichen Lösungen gibt, die sich als Unterräume des Lösungsvektorraums darstellen lassen.

Im Extremfall sind überhaupt keine geschlossenen Modellgleichungen angebbar, was dazu führt, daß zunächst einmal alle Lösungsvektoren im Parameterraum im deterministischen Sinne gleichwertig sind.

Das ist z.B. der Fall, wenn von einem Energiespeicher, dessen Kennlinie, Alter und Wirkungsgrad unbekannt sind, die verfügbare Kapazität gemessen werden soll.

Anders sieht es allerdings aus, wenn man die möglichen Lösungsvektoren unter der Zuhilfenahme von Vorwissen betrachtet. Dieses Vorwissen beinhaltet zunächst nur das Erfahrungswissen über die behandelte Akkuklasse im allgemeinen (z.B. NiCd-Akku, Blei-Akku, Natrium-Akku) sowie über den Akku-Typ im speziellen (Hersteller, Größe, Nennparameter) und setzt sich zusammen aus den bzgl. des Prozesses bekannten Regeln und den dazugehörigen Fakten (Daten).

Kennt man zusätzlich noch individuelle Daten des vorliegenden Akkus oder bereits Meßwerte aus dem aktuell laufenden Prozeß, können auch diese Informationen mittels spezifischer Richtlinien zur Schätzung des Systemzustands herangezogen werden.

Wie beim Messen mit Beobachterprinzip werden nach jedem Meßvorgang die Prozeßausgangsgrößen, in diesem Fall also die Spannung, mit den korrespondierenden Größen des Modells verglichen und im Falle von Abweichungen mittels eines regelbasierten Adaptionsalgorithmus angepaßt. Ein einfaches Verstärken (bzw.

Dämpfen) oder ein Nachstellen in einem einfachen Regelkreis (z.B. PID-Regler mit einer Zeitkonstanten deutlich kleiner als die Abtastzyklus-Dauer) reicht für diesen Zweck nicht aus. Zwar erreichte man damit das primäre Ziel - nämlich die Minimierung der momentanen Abweichung -, die Parameter würden dabei aber nicht hinsichtlich der Plausibilitätskriterien überprüft, die sich aus dem Erfahrungswissen ergeben.

Dagegen geht bei jedem Schritt in der iterativen regelbasierten Parameter-Schätzung das gesamte Vorwissen aus dem vorliegenden Prozeß ein und nur im Fall einer plausiblen Parameterkonfiguration wird wieder in den Wartezustand zurückgekehrt, der erst nach dem Vorliegen neuer Meßwerte wieder verlassen wird.

Unter bestimmten Voraussetzungen (etwa bei gröberen Abweichungen zwischen zwei Meßtakten) kann es dabei erforderlich werden, die bisher durchlaufene reale Kennlinie nochmal auf

Plausibilität hinsichtlich der neu geschätzten Parameter zu überprüfen ("Backward Tracing"). Ähnlich verhält es sich mit dem zukünftig zu erwartenden Prozeßverlauf; auch er muß dann auf Plausibilität überprüft werden ("Forward Tracing") und nur bei einem vernünftigen Ergebnis beider Zweige werden die Parameter als plausibel erklärt.

Findet man für die aktuelle Prozeßkonfiguration keinen plausiblen Parametersatz auf der Basis derjenigen aus dem letzten Meßtakt, ist als weiterer Schritt das sogenannte "Backtracking" anzuwenden. Hierfür werden in regelmäßigen Abständen die Meß- und Parameterwerte zwischengespeichert, um im nachhinein auf diese Werte zurückgreifen zu können. Von dort aus wird dann erneut versucht, unter Berücksichtigung der Prozeß-Information über die Zwischenzeit auf eine eher plausible Parameterkonfiguration am aktuellen Arbeitspunkt zu gelangen.

In bestimmten Situationen (etwa bei Störungen von außen oder bei Hochstromentladungen) kann auch ein vorzeitiger Rekalibrierungsvorgang erforderlich werden. Dieser wird standardmäßig nur an den "Eckpunkten", d.h. beim Umschalten von Be- und Entladung und umgekehrt, durchgeführt.

Bei dieser Rekalibrierung werden diejenigen Parameter angepaßt, die sich in der Regel nur wenig ändern und unter bestimmten Voraussetzung (bei Volladung oder Totalentladung) mit den korrespondierenden Größen des Prozesses verglichen werden können. Ist diese Vergleichsmöglichkeit nicht gegeben oder gelangt man trotz Anwendung aller beschriebenen Verfahren nicht mehr zu einer vernünftigen Parameterkonstellation, müssen diese Parameter aus dem bis zu diesem Zeitpunkt angesammelten Wissen neu geschätzt werden.

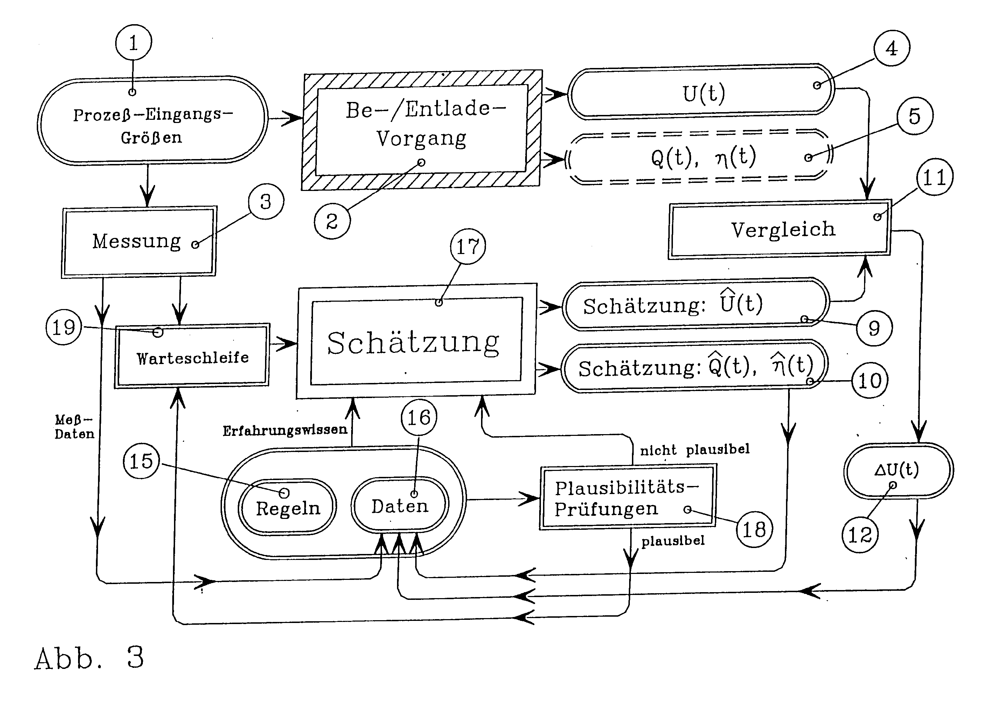

Die Vorgehensweise bei der heuristischen Parameteranpassung ist in Abb. 3 schematisch dargestellt. Die Schritte 1 bis 5 entsprechen denen in Abb. 2.

Anders als beim Messen mit Beobachterprinzip kann jedoch keine Modell-Rechnung stattfinden, weil kein geschlossenes Gleichungssystem zur Verknüpfung der Meßgrößen aus (3) zur Verfügung steht. Die rechnerisch ermittelten Prozeß-Ausgangs-Größen (9) und (10) werden stattdessen nach aus der Erfahrung stammenden Regeln (15) zusammen mit den bis zu diesen Zeitpunkt bekannten Daten über den individuellen Akku (16) geschätzt (17). Danach werden die neu hinzugekommenen Daten (9), (10), (11) und (12) in die Datenbasis (16) eingetragen und mit der neuen Konstellation wird eine Reihe von Plausibilitäts-Prüfungen durchgeführt (18). Führen diese Prüfungen an einer Stelle zu einem nicht tolerierbaren Widerspruch mit der Erfahrung, wird eine erneute Schätzung, möglicherweise unter Verwendung einer der oben beschriebenen Verfahren, durchgeführt (17). Dieser Schätzungszyklus wiederholt sich - immer noch auf der Basis einer einzigen neu hinzugekommenen Messung - solange, bis eine plausible Parameterkonstellation gefunden wurde (19), die nicht weiter verbessert werden kann. Diese gilt dann bis zum Zeitpunkt der darauffolgenden Messung (3).

Der Fall, daß keine plausible Parameterkonstellation gefunden wird, ist nicht vorgesehen. Mit einem geeigneten Regelsatz kann dies ausgeschlossen werden. So wird z.B. nach dem Einsetzen einer vorher unbekannten Batterie und der Durchführung der ersten Messung kein Parametersatz gefunden werden, der in allen Belangen so plausibel ist, wie derjenige im Fall einer Batterie, bei der die letzten 50 Be- und Entladezyklen im selben Gerät protokolliert wurden.

Hier muß dann die Annahme der Nenngrößen aus der Katalog-Tabelle für einen neuen Akku solange als plausibel gelten, bis die Meßdaten auf etwas anderes schließen lassen.

Bei den Plausibilitäts-Prüfungen gibt es also Toleranzfelder für die Parameter-Konstellation, die auf einen zu erwartenden Fehler im Meßwert schließen lassen. Da mit der Zeit, also je länger Monitor und Batterie zusammenarbeiten, die Toleranzfelder für die Parameter immer enger werden, ist damit auch eine Verbesserung der Meßwertqualität des Monitors verbunden.

## 3.3.. Verfahrenskombinationen

Die Bestimmung des Ladezustands eines reversiblen elektrische Energiespeichers wird durch eine Kombination Zweien Verfahren erreicht, nämlich mittels Adaption der Parameter über das Beobachterprinzip und mit heuristischen Methoden. Beide Ansätze sind auf beide Teilzweige, den Be- und Entladezweig der Kennlinie,

EP 0 471 698 B1

anwendbar und beschreiben auf deterministische oder heuristische Weise das Be- und Entladeverhalten des Akkumulators.

Beide Teilzweige jeweils für sich ermöglichen bereits die Extraktion ausführlicher Informationen über die aktuellen Akkuparameter. Obige Kombination ist für den Einsatz in einer Ausführung des Monitor denkbar. Dieser kann daher ausgeführt werden als Bestandteil

a) nur des Ladegeräts
b) nur des Verbrauchergeräts
c) der Batterie

wobei Mischformen möglich sind.

### 3.4. Modellansätze

Die in 3.1 und 3.2 beschriebenen Methoden stellen Idealfälle dar, die beide bei realen Akkus praktisch nicht vorkommen. Weder der Fall, daß ein Akku in seinem gesamten Arbeitsbereich in Abhängigkeit aller Zustandsvariablen geschlossen beschreibbar ist, noch ein völliges Fehlen modellartiger funktionaler Zusammenhänge kommt bei einem der gängigen Typen zum Tragen. Daher handelt es sich bei den behandelten Modellansätzen meistens um Kombinationen von deterministischen und phänomenologischen Funktionen sowie heuristischen Komponenten. Am Beispiel des NiCd-Akkus wird im folgenden dargestellt, welche Typen von Gleichungen herangezogen werden können.

### 3.1 Belademodell

Die Beladespannung des NiCd-Akkus kann aus dem über die Butler-Volmer-Gleichung abgeleiteten deterministischen Ansatz für die Durchtrittspannung und einem phänomenologischen Ansatz für die Differenzspannung dargestellt werden als:

$$(3.1) \qquad U_B = U_{ZG} + \frac{arsinh\left(\frac{I_B}{2I_0}\right)}{\alpha z f} - \frac{ln\left(\alpha_{U_D} \cdot I_B\right)}{P(L)} + U_{D_0}$$

Alle Größen auf der rechten Seite der Gleichung sind mit Ausnahme der Beladestromstärke $I_B$ und des Ladezustands L geeignet zu wählende Konstanten bzw. Modellparameter (z.B. $u_D$, $U_{ZG}$ Z, f).

P(L) ist ein Polynom, das durch numerische Approximation aus gemessenen Kennlinien ermittelt wird. Die Beladestromstärke kann direkt gemessen werden; der aktuelle Ladezustand kann aus der Bilanzierung der eingeladenen Ladungsmenge bestimmt werden, wenn man den differentiellen Ladewirkungsgrad $\eta_L$ kennt. Dieser ist definiert als die aus einer Ladungseinlagerung resultierende entnehmbare Ladungsmenge:

$$(3.2) \qquad \eta_L = \frac{\delta L}{\delta Q_B} \rightarrow \eta L = \frac{dL}{dQ_B}$$

Der differentielle Ladewirkungsgrad ist vom Beladestrom und vom aktuellen Ladezustand abhängig, wobei man diese Abhängigkeit ebenfalls durch einen phänomenologischen Ansatz darstellen kann:

$$\eta_L(L, I_B) = e^{P_{\eta_L}(L) \cdot I_B} + P_{\eta_{L_0}}(L)$$

$$(3.3)$$

$P_m(L)$ und $P_{\eta_{L_0}}(L)$ sind Polynome (Ordnung ca. $\eta = 5$)

Mit dem bekannten differentiellen Ladewirkunsgrad läßt sich die tatsächlich verfügbare Ladungsmenge aus der eingelagerten Ladungsmenge bilanzieren.:

$$L = \sum_{Q_{B_i}} \eta_L \cdot \Delta Q_{B_i}$$

$$bzw.$$

$$(3.4) \qquad L = \int_{Q_{B_0}}^{Q_B} \eta_L\left(L^*, I_B\right) dQ_B^*$$

und damit kann der modellierte Spannungswert nach (3.1) angegeben werden.

6

Soweit der gemischt deterministische und phänomenologische Modellansatz für die Beladespannung des NiCd-Akkus.

Wird jetzt beispielsweise ein unbekannter NiCd-Akku in ein Ladegerät mit Monitorfunktion eingesetzt und an seinen Klemmen die Spannung U(t) und der Strom I(t) gemessen, stimmt die modellierte Spannung $U_B(t)$ nach (3.1) nur dann mit der gemessenen Spannung überein, wenn es sich um einen

- neuen
- leeren
- keiner Exemplarstreuung unterliegenden

NiCd-Akku handelt. In allen anderen Fällen gibt es eine Spannungsdifferenz, für deren Ausgleich es zunächst einmal die Möglichkeit gibt, ca. 20 Parameter der Gleichungen 3.1 und 3.3 zu verändern. Man findet beliebig viele Vektoren in diesem Parameterraum, die dafür sorgen, daß die Spannungsdifferenz verschwindet. Um aus diesen Vektoren die vernünftigen auszusuchen, sei z.B. folgende Regel genannt.

Nach dem Ansatz der Monitorfunktion wird zunächst von einer leeren Batterie ausgegangen, soweit nichts anderes bekannt ist. Ist nun aber die eingesetzte Batterie nur zur Hälfte entladen, stellt sich eine erheblich gröbere Spannung ein, als das Modell unter der Annahme einer leeren Batterie voraussagt. Es ist nun für den Monitor das Naheliegenste, die Annahme zu verwerfen, daß die Batterie leer sei. Die Regel liebe sich formulieren als:

Regel 1

Wenn  eine Batterie neu eingesetzt ist
und    keine weiteren Informationen vorhanden sind
und    die Spannung an den Klemmen zu grob ist,
dann   ist die Batterie höchstwahrscheinlich nicht leer
also    höheren Ladezustand annehmen

Vor dem nächsten Meßtakt wird jetzt der zunächst als Null angenommene Ladezustand z. B. mittels einer PID-Regelcharakteristik erhöht, so daß der Fehler, d. h. die Spannungsdifferenz kleiner wird. Nach einigen Meßtakten wird das System sich angepaßt haben und die Spannungsdifferenz wird sehr klein geworden sein. Nun kann aber auch die Annahme, die Batterie sei neu und treffe zufälligerweise gerade die Katalogwerte mit ihren Parametern, durchaus falsch gewesen sein. In diesem Fall ist der jetzt angenommene Ladezustand zu groß. Dieser Irrtum kann aus den Kennlinienmerkmalen abgelesen werden, nachdem eine Reihe von Meßtakten durchlaufen wurde. Stimmen die Kennlinienmerkmale der real gemessenen Kurve nur schlecht mit denen des Modells überein, kann eine erneute Schätzung der individuellen Nennkapazität (die vom Alter und von der Exemplarstreuung abhängt) durchgeführt werden und die Modellkennlinie vom Zeitpunkt des Modellansatzes bis zum Arbeitspunkt neu berechnet und wieder mit der realen Kennlinie verglichen werden. Dabei ergibt sich zwangsläufig ein anderer, nämlich kleinerer Ladezustand. Der geschätzten und für plausibel befundenen individuellen Nennkapazität entspricht zunächst ein Satz von Lösungsvektoren aus dem zweidimensionalen Raum der denkbaren Verschleißzustände und durch Exemplarstreuung bedingter Schwankung dieser Größe, solange es keine Hinweise für die Einschränkung dieser Menge gibt.

Regel 2 kann also angewendet werden, wenn bereits ein Teil der Beladekennlinie durchlaufen wurde:

Regel 2

Wenn        Regel 1 angewendet wurde
und         die Kennlinien-Merkmale nur schlecht übereinstimmen
dann   stimmt die angenommene individuelle Nennkapazität nicht
also    individuelle Nennkapazität so anpassen, daß
        a) ein plausibler Kennlinienverlauf entsteht,
        b) Spannungsdifferenz unter der dann anzunehmenden Ladekapazität minimal wird

Der Kennlinienverlauf wird anhand von leicht extrahierbaren Merkmalen verglichen wie Krümmung, Steigung, Absolutwert und Integral (entnommene Energie).

### 3.4.2. Entlademodell

Der Verlauf der Entladekennnlinie zeigt drei deutlich voneinander abgrenzbare Bereiche:
1) Ein rascher Abfall zu Beginn der Entladung
2) Ein langer, nahezu linearer Abfall mit geringer Steigung
3) Ein plötzlich einsetzender, steiler Abfall

Der Modellansatz besteht demnach aus einem linearen (genauer: affinen) Hauptteil, dem am Anfang und am Ende jeweils eine Exponentialfunktion überlagert ist.

Die Komponenten werden als Initial-, Linear- und Finalteil bezeichnet und werden folgendermaßen formuliert:

$$(3.5) \qquad U_E(Q_E) = U_{E_i}(Q_E) + U_{E_l}(Q_E) - U_{E_f}(Q_E)$$

$$(3.5.a) \qquad U_{E_l}(Q_E) = U_{E_{l_0}}(Q_E) + m_{U_{E_l}} \cdot Q_E$$

$$(3.5.b) \qquad U_{E_i}(Q_E) = U_{E_{i_0}} \cdot e^{-\kappa U_{E_i} \cdot Q_E}$$

$$(3.5.c) \qquad U_{E_f}(Q_E) = U_{E_{f_0}} \cdot e^{\kappa U_{E_f} \cdot Q_E}$$

Ähnlich wie in 3.4.1 wird nach dem Einsetzen einer unbekannten Batterie zunächst von den Normalwerten eines vollgeladenen Exemplars ausgegangen.

Nun kann aber aus der Adaption der Initialparameter nicht direkt auf die eigentlich interessierende Größe, nämlich die aktuelle Finalbeginn-Ladung, geschlossen werden.

Die dem Initialverlauf entnommenen Parameter lassen aber eine verbesserte Schätzung des Finalverlaufs zu. Noch besser wird diese Schätzung, wenn auch der Linearteil ausgewertet werden konnte und am besten ist der Finalverlauf voraussagbar, wenn das System sich diesen Verlauf bei der letzten Entladung merken konnte.

Die folgenden beiden Regeln seien für das bedingte Ableiten von Informationen aus den Meßwerten beispielhaft genannt.

Regel 3

Wenn     der aus dem Kurvenverlauf ermittelte Beginn des linearen Bereiches typisch für eine halbverschlissene Batterie ist

und     sonst keine Informationen vorliegen

dann     ist die Batterie höchstwahrscheinlich halb verschlissen

Regel 4

Wenn     der aus dem Kurvenverlauf ermittelte Beginn des linearen Bereiches typisch für eine halbverschlissene Batterie ist

und     die Batterie im letzten Zyklus erst als zu einem Viertel verschlissen eingestuft wurde

und     es keine außergewöhnlichen Vorfälle im laufenden Zyklus gab,

dann     ist die Batterie höchstwahrscheinlich nur wenig mehr als zu einem Viertel verschlissen

Die Zahlenwerte und Begriffe wie "höchstwahrscheinlich" sind beispielhafte Aussagen, die im tatsächlich ablaufenden Programm durch Zahlen, d. h. Wahrscheinlichkeitswerte, Verschleißzahlen etc., ersetzt werden. Diese Zahlen sind typspezifisch; es soll in diesen einfachen Regeln nur exemplarisch dargestellt werden, wie die Ergebnisse von Messungen mit dem Vorwissen verknüpft werden.

**Ausführungsbeispiele**

Es ergeben sich verschiedene Versionen von Vorrichtungen zur Realisierung des beschriebenen Verfahrens. Die Beschränkungen sind dabei, daß bei reinen Ladegeräten (in die der Akku in irgendeinem Zustand eingesetzt und im Regelfall vollgeladen entnommen wird) nur der Beladezweig, sowie umgekehrt bei einem reinen Verbrauchergerät (in das ein voller Akku eingesetzt und leer entnommen wird) nur der Entladezweig ausgewertet werden kann.

Beim Einsatz des Monitors als Bestandteil des Akkus bzw. eines Akku-Package wird die Auswertung beider Zweige unterstützt. Das gleiche gilt für Verbrauchergeräte, die der Akku für die Aufladung nicht verläßt. Dabei spielt es nur eine untergeordnete Rolle, ob der Akku fest verlötet oder leicht wechselbar ist. Beim Einsatz unbekannter Akkus ergeben sich lediglich längere Adaptionsphasen, bis sich wieder die maximal erreichbare Meßgenauigkeit eingestellt hat.

Doch auch bei der Verwendung der Monitorfunktionen in den dem jeweiligen Kennlinienzweig entsprechenden Geräten gibt es die Möglichkeit, beide Verläufe auszuwerten, wenn der Akku seine aktuellen Informationen auf einem Halbleiterspeicher (RAM oder EEPROM) mitgegeben bekommt und diese dem jeweils anderen Gerät mitteilt. Auch wenn nur eins der beiden Geräte über den Monitor verfügt, wird hierdurch der Vorteil geschaffen, daß der Monitor über die aktuelle Kennlinie hinaus auf die Ergebnisse aus früheren Kennlinienauswertungen bzgl. dieses Akkus zurückgreifen kann.

Es ergeben sich insgesamt die im folgenden dargestellten Realisierungsformen des Monitors.

1. Der Monitor ist nur Bestandteil des Ladegeräts

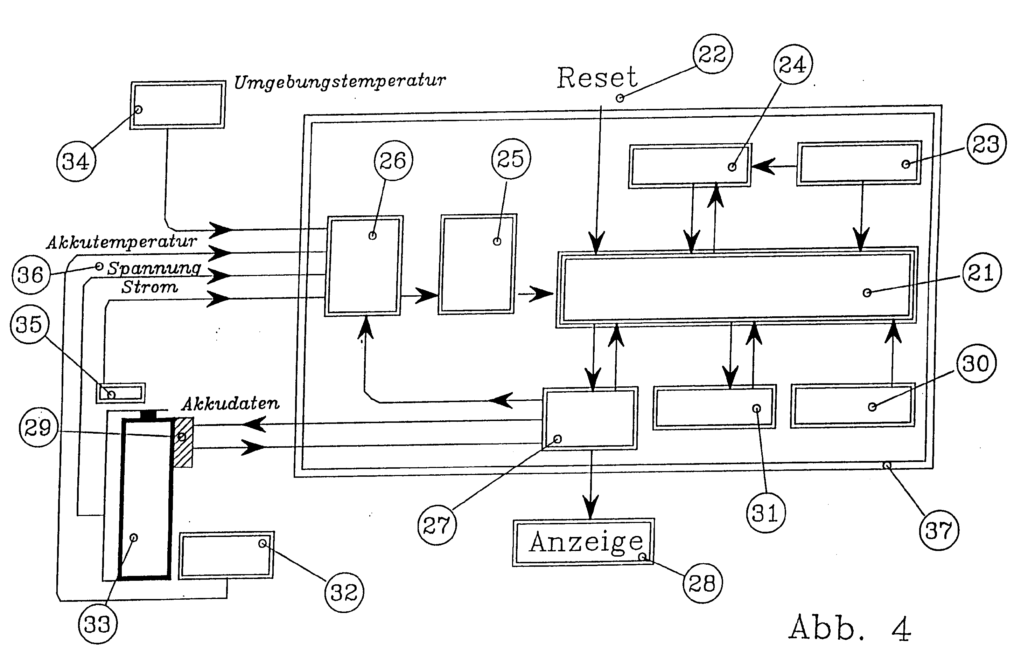

Das Ladezustands-Überwachungssystem ist eine dem Ladegerät fest zugeordnete Vorrichtung zur Durchführung der unter 3.1 und 3.2 beschriebenen Verfahren. Abb. 4 zeigt ein Blockschaltbild einer solchen Vorrichtung, in dem die einzelnen Komponenten aufgeführt sind sowie ihre jeweilige Wechselwirkung durch Pfeile angedeutet ist. Der zentrale Baustein dieses diskreten Aufbaus ist ein Mikroprozessor (21), der als 8-Bit-Mikrorechner gleichermaßen kostengünstig und platzsparend ist und auf der anderen Seite über alle notwendigen Leistungsmerkmale für diesen Einsatz verfügt. Bei entsprechenden Genauigkeits- und Geschwindigkeitsanforderungen kann aber auch ein 32-Bit-Rechner eingesetzt werden.

Vom Ladegerät 28 mit einer Anzeigeeinheit bekommt der Monitor (21, 23, 24, 25, 26, 27, 30, 31) = (37) neben seiner Versorgungsspannung einen RESET-Impuls (22), nachdem der Akku (33) eingesetzt und der Beladevorgang gestartet wurde. Die Zeitbasis wird durch einen Taktgeber (23) gestellt, der als Quartz oder als elektronischer Schwingkreis ausgeführt sein kann und neben dem CPU-Takt auch für den Timer-Takt mittels CTC=Zähler-Timer-Schaltung (24) sorgt, der die Interrupts für die Meßwert-Aufnahme generiert. Diese wird von einem Analog-Digital-Wandler durchgeführt (25), der das von einem Multiplexer (26) selektierte Meßsignal digitalisiert an die CPU (21) sendet.

Die Auswahl des Eingangskanals trifft der Rechner über einen I/O-Baustein (27), der auch für die Ausgabe des digitalen Ergebnisses an das Ladegerät (28) sowie ggf. für die Kommunikation mit dem Akku-Speicher (29) genutzt wird.

Programme und akku- bzw. gerätespezifische Daten werden auf einem nichtflüchtigen Halbleiterspeicher (ROM, PROM, EPROM, EEPROM,) (30) auf das System gebracht. Dieser Baustein ist der einzige, der bei der Übertragung des Systems auf ein anderes Trägergerät geändert werden muß. Für den Programm-Ablauf bzw. Einspeisung wird zusätzlich ein flüchtiger Speicher (SRAM, DRAM) (31)) benötigt.

In der Peripherie ist am Ladegerät (28) neben der erwähnten Anzeige ein Temperatursensor (32) am Akku (33) zu installieren, sowie ein Sensor für die Umgebungstemperatur (34) und ein Strom-Sensor (35). Dieser kann z.B. als Hall-Sensor ausgeführt sein, um den Prozeß möglichst wenig zu beeinflussen. Das Eingangssignal für die Spannung wird an den jeweils aktiven Klemmen des Ladegeräts mittels Sensor (36) abgegriffen.

2. Der Monitor ist nur Bestandteil des Verbrauchergeräts

Dieser Aufbau entspricht dem in Abb. 4 dargestellten Schema; der Monitor kann, wie beim Ladegerät, mit und ohne die Speichereinrichtung am Akku betrieben werden.

3. Der Monitor ist Bestandteil der Batterie

Ganz ohne Schnittstelle und Datentransfer kommt man aus, wenn der Monitor fester Bestandteil des Akkus oder eines Akku-Packages ist. Sowohl Be- wie auch Entladezweig werden ausgewertet und alle Monitorfunktionen optimal genutzt. Alle Daten der Batterie werden von Beginn an individuell gespeichert und können durch die Verwendung eines nichtflüchtigen Speichers auch über den Spannungsnulldurchgang hinweg erhalten bleiben. Zwar ist diese Datenerhaltung nicht für die Funktionalität des Systems erforderlich, da auch bei Datenverlust eine erneute Anpassung erfolgt, jedoch wird eine Vergrößerung der Fehlerintervalle vermieden, die mit einem erneuten Adaptionsstart mit der dann wieder unbekannten Batterie einhergeht.

4. Der Monitor ist ein auf Verbrauchergerät und Ladegerät verteiltes System, wobei die Batterie auf einem Speicher ihre aktuellen Daten mitgegeben bekommt.

Die vollständige Ausnutzung aller Monitorfunktionen ist auch dann gewährleistet, wenn Ladegerät und Verbrauchergerät jeweils über eine Vorrichtung nach Abb. 4 verfügen und der Akku in einem ihm fest verbundenen, nichtflüchtigen Halbleiterspeicher seine Informationen mit sich führt, um sie stets dem jeweils anderen Gerät wieder zum Aufsetzen des Überwachungsvorgangs mitzuteilen. Für den Fall eines flüchtigen Speichers gelten die oben erwähnten Fehleraussagen entsprechend.

5. Der Monitor wird als ASIC mit verschiedenen Programmen für alle Anwendungen 1-4 realisiert

Um z. B. grobe Stückzahlen preisgünstig herstellen zu können, oder um die Unterbringung des Monitors auf engem Raum zu ermöglichen, kann die Vorrichtung auch als hochintegrierter Baustein (ASIC) ausgeführt werden.

Um möglichst in allen Realisierungsformen nach 1 bis 4 eingesetzt werden zu können, müssen dem Baustein alle dafür erforderlichen Programme mitgegeben werden, die jeweils eine laufende Nummer erhalten, an Hand derer man sie selektieren kann.

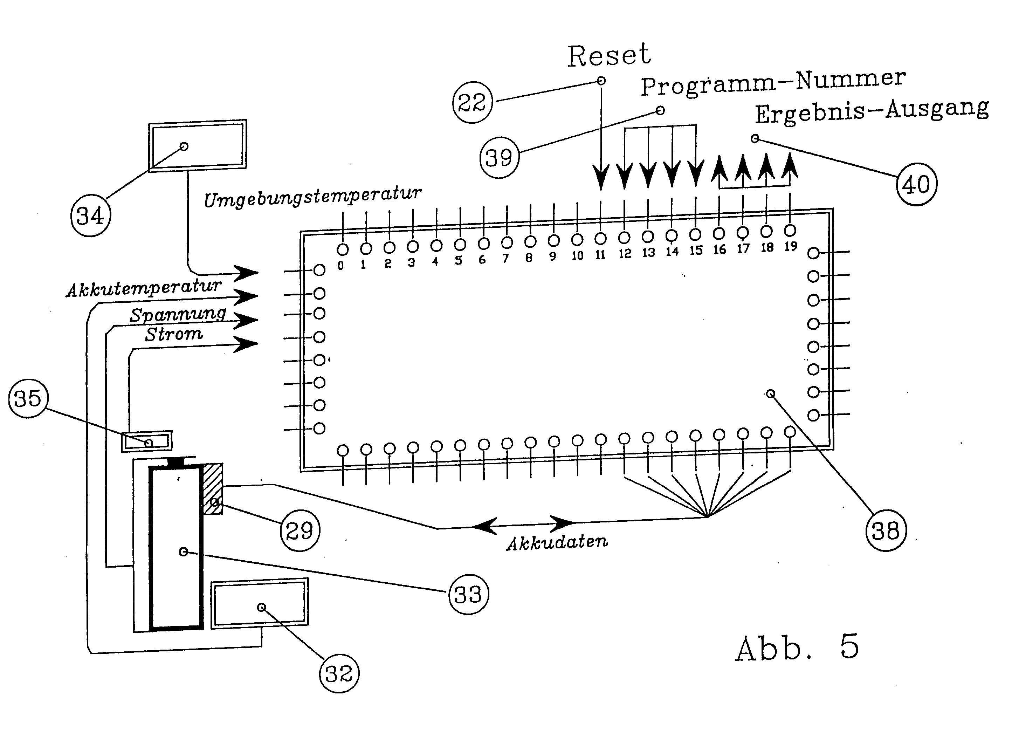

Abb. 5 zeigt schematisch einen Aufbau, bei dem die in Abb. 4 innerhalb des Rahmens (37) befindlichen Bauteile als Makros für den Aufbau des hochintegrierten Bausteins (38) verwendet werden können. Das Trägergerät übergibt dem Chip eine vierstellige binäre Programmnummer (39), die die Einsprungstelle in das Monitorprogramm auswählt, an die zum Programmstart nach dem RESET (22) gesprungen werden

9

soll. Die Funktionalität entspricht dann dem jeweiligen für diese Aufgabe spezifizierten diskreten Aufbau.

So werden die Meßwerte, die die Be-/Entladekennlinie liefern von Bauteil (38) an Speicher (29) weitergegeben bzw. von ihm angefordert. Bei Kenntnis des Fabrikats und damit der Daten des Energiespeichers können diese über eine Programm-Eingabe (39) eingegeben werden, gröbere Fehlerintervalle werden somit vermieden.

Über die Pins 16 - 19 wird das vierstellige binäre Ergebnis (bei Bedarf auch mit gröberer Wortlänge) an das Trägergerät (40) übergeben.

**Liste der Symbole**

| | |
|---|---|
| $f$ | Abkürzung für $F/R\,T$ |
| $I$ | Stromstärke |
| $I_o$ | Grund-Stromstärke |
| $I_B$ | Belade-Stromstärke |
| $m_{UEI}$ | Steigung des Linearteils der Entlade-Spannung |
| $Q_B$ | Zugeführte Ladung (Beladen) |
| $Q_E$ | Entnommene Ladung |
| $U_{Ef}$ | Finalteil der Entlade-Spannung |
| $U_{Ei}$ | Initialteil der Entlade-Spannung |
| $U_{EI}$ | Linearteil der Entlade-Spannung |
| $E_{EIo}$ | lineargrundspannung |
| $U_{ZG}$ | Zellengleichgewichtsspannung |
| $z$ | Wertigkeit |
| $\alpha$ | Durchtrittsfaktor |
| $\eta L$ | Differentieller Ladewirkungsgrad |

**Patentansprüche**

1. Verfahren zur Bestimmung des Ladungszustandes und weiterer physikalischer Größen, wie Verschleißzustand, Alter, Exemplarstreuung, Vorgeschichte und Ladewirkungsgrad, eines wiederaufladbaren elektrischen Energiespeichers, wobei Prozeßeingangsgrößen ($I$, $t$, $T_{Akku}$, $T_{Umg}$; $U(t)$) des Energiespeichers gemessen und in einem Rechner verarbeitet werden, wobei nach dem Prinzip des indirekten Messens ein vorgebbares Modell, in Form nicht-linearer mehrparametriger Funktionen, das den Ladungszustand und die zu bestimmenden physikalischen Größen und ihre physikalischen Beziehungen zueinander repräsentiert, mit den gemessenen Prozeßeingangsgrößen verglichen wird und für die nachfolgende Messung im Falle von Abweichungen die Modellparameter adaptiert werden,
**dadurch gekennzeichnet,**
daß zur Ermittlung des Ladungszustandes und der zu bestimmenden physikalischen Größen eine vielparametrige Beschreibung in Form des Modells und einer heuristischen Parametrierung verwendet wird, wobei die Beschreibung mehr Parameter aufweist als Prozeßeingangsgrößen und die unterbestimmte Lösungsmenge des Modells zunächst und dann der Ladungszustand und die weiteren physikalischen Größen mit Hilfe der Parametrierung als Schätzung unter Verwendung von Kennlinien und Daten bekannter Energiespeicher bestimmt wird.

2. Verfahren nach Anspruch 1,
**dadurch gekennzeichnet,**
daß die beim Be-/Entladevorgang gemessene Spannung $U(t)$ mit der Modell-Ausgangsgröße $\hat{U}(t)$ verglichen wird und die Spannungsdifferenz überwacht wird und daß zur Minimierung der Spannungsdifferenz $\Delta U(t)$ die Modellparameter mit Hilfe der Modellgleichungen und der gemessenen Prozeßeingangsgrößen für die nachfolgende Messung ein oder mehrfach neu berechnet werden.

3. Verfahren nach Anspruch 1,
**dadurch gekennzeichnet,**
daß aus den gemessenen Prozeßeingangsgrößen und Verwendung der derselben Messung zugeordneten Regeln und Daten die neue Schätzung berechnet und daraus die geschätzten Ausgangsgrößen $\hat{U}(t)$ und $\hat{Q}(t)$ und $\hat{\eta}_L(t)$ ermittelt werden, wobei $\hat{Q}(t)$ die geschätzte entmehmbare Ladungsmenge und $\hat{\eta}_L(t)$ der geschätzte differentielle Ladewinkungsgrad bedeuten.

**4.** Verfahren nach Anspruch 3,
**dadurch gekennzeichnet,**
daß eine Plausibilitätskontrolle der neuen Parameterschätzung durchgeführt wird.

**5.** Verfahren nach Anspruch 4,
**dadurch gekennzeichnet,**
daß die Plausibilitätskontrolle der neuen Parameter für die vorhergehenden und die zukünftigen Messungen durchgeführt wird und danach ein Vergleich der geschätzten mit den gemessenen Werten ein- oder mehrfach durchgeführt wird.

**6.** Verfahren nach einem der Ansprüche 1 - 5,
**dadurch gekennzeichnet,**
daß die während der Messung durchlaufene reale Kennlinie auf Plausibilität hinsichtlich der neu geschätzten Parameter überprüft wird und/oder der zu erwartende Prozeßverlauf auf Plausibilität hinsichtlich der neu geschätzten Parameter überprüft wird.

**7.** Verfahren nach einem der Ansprüche 1 - 6,
**dadurch gekennzeichnet,**
daß die Meß- und Parameterwerte gespeichert werden und die Parametrierung mit solchen bereits gespeicherten Werten durchgeführt wird.

## Claims

**1.** Method of determining the charging state and other physical parameters such as condition of wear, age, specimen deviation, history and charge efficiency of a rechargeable electric energy storing apparatus, wherein process input values $(I, t, T_{Akku}, T_{Umg}; U(t))$ of said energy storing apparatus are measured and processed in a computer, wherein, following the principle of indirect measurement, a predeterminable model in the form of non-linear measurement, a rametric functions, which represents the charging state and the physical parameters to be determined as well as their mutual physical relationships, is compared against the measured process input values and the model parameters are adapted for the subsequent measurement in the event of deviations,
**characterized in**
that a multiparametric description in the form of the model and a heuristic parametering technique are employed to determine the charging state and said physical parameters to be determined, with said description including more parameters than process input values and the underdetermined set of solutions of said model is determined first, whereupon the charging state and said other physical parameters are determined by means of said parametering technique as estimated values, using characteristics and data of known energy storing apparatuses.

**2.** Method according to Claim 1,
**characterized in**
that the voltage $U(t)$ measured during the charging/discharging cycle is compared against the model output value $U(t)$ and the voltage difference is monitored, and in that for minimizing the voltage difference $\Delta U(t)$ the model parameters are newly calculated once or repeatedly by means of said model equations and said measured process input values are are newly calculated once or repeatedly for the subsequent measurement.

**3.** Method according to Claim 1,
**characterized in**
that the new estimate is calculated from the measured process input values, using the rules and data associated with the same measurement, and that the estimated output values $U(t)$ and $Q(t)$ as well as $_2(t)$ are derived therefrom, with $Q(t)$ denoting the estimated tappable charge and $_2(t)$ representing the estimated differential charge efficiency.

**4.** Method according to Claim 3,
**characterized in**
that a plausibility check of the new parameter estimate is carried out.

**5.** Method according to Claim 4
**characterized in**
that said plausibility check of the new parameters is carried out for the previous and the future measurements and that subsequently a comparison of the estimated and measured values is conducted once or repeatedly.

**6.** Method according to any of Claims 1 to 5,
**characterized in**
that the real characteristic of the measurement cycle is checked for plausibility in view of the newly estimated parameters and/or the course of the process to be expected is checked for plausibility with respect to the newly estimated parameters.

**7.** Method according to any of Claims 1 to 6,
**characterized in**
that said measured and parameter values are stored and that said parametering technique is carried out with such values already stored.


**Revendications**

**1.** Procédé de déterminer l'état de charge et des autres quantités physiques comme l'état d'usure, l'âge, dispersion des spécimens, histoire et le rendement de charge d'un réservoir d'énergie électrique rechargable, dans lequel des valeurs d'entrée de processus (I, t, $T_{Akku}$, $T_{Umg}$; U(t)) dudit réservoir d'énergie sont mesurées et traitées dans un ordinateur, dans lequel procédé un modèle prédéterminable sous forme de fonctions non-linéaires à plusieurs paramètres, qui représente l'état de charge et les quantités physiques à déterminer ainsi que leurs relations physiques mutuelles, est comparé, suivant le principe de mesure indirect, avec lesdites valeurs d'entrée de processus mesurées, et les paramètres du modèle sont adaptés pour le mesurage suivant s'il y a de déviations,
**caractérisé en ce**
qu'une description à plusieurs paramètres sous forme du modèle ainsi qu'une technique heuristique paramétrique sont utilisées pour déterminer l'état de charge et lesdites quantités physiques à déterminer, ladite description comprenant un nombre de paramètres qui est plus grand que le nombre de valeurs d'entrée du processus, et l'ensemble sous-déterminé de solutions dudit modèle étant déterminé d'abord, et l'état de charge et les autres quantités physiques étant déterminés, moyennant ladite technique paramétrique, ensuite comme estimation approximative, en utilisant des courbes caractéristiques et les données des réservoirs d'énergie connus.

**2.** Procédé selon la revendication 1,
**caractérisé en ce**
que la tension U(t) mesurée au cours du cycle de charge/décharge est comparée avec la valeur de sortie du modèle U(t) et la différence de tension est surveillée, et en ce que, pour la minimalisation de la différence de tension $\Delta U(t)$, les paramètres du modèle sont calculés de nouveau, soit une ou plusieurs fois, moyennant les équations modèles, et lesdites valeurs d'entrés mesurées du processus sont calculées de nouveau, soit une ou plusieurs fois, pour le mesurage suivant.

**3.** Procédé selon la revendication 1,
**caractérisé en ce**
que l'estimation approximative est calculée en la dérivant desdites valeurs d'entrée mesurées du processus, moyennant les règles et données affectés au même mesurage, et en ce que les valeurs de sortie estimées U(t) et Q(t) ainsi que $_2$(t) sont en dérivées, Q(t) indiquant la charge prélevable estimée et $_2$(t) représentant le rendement différentiel estimé de charge.

**4.** Procédé selon la revendication 3,
**caractérisé en ce**
qu'un contrôle de plausibilité de la nouvelle estimation approximative de paramètres est réalisé.

**5.** Procédé selon la revendication 4,
**caractérisé en ce**
que ledit contrôle de plausibilité des nouveaux paramètres est réalisé pour les mesurages préalables et à réaliser encore, et en ce qu'ensuite une comparaison des valeurs estimées et mesurées est établie, soit une ou plusieurs fois.

6. Procédé selon une quelconque des revendications 1 à 5,
   **caractérisé en ce**
   que la courbe caractéristique réelle du cycle de mesure est contrôlée pour sa plausibilité en vue des nouveaux paramètres estimés et/ou le cours du processus à attendre est vérifié pour sa plausibilité en vue des nouveaux paramètres estimés.

7. Procédé selon une quelconque des revendications 1 à 6,
   **caractérisé en ce**
   que lesdites valeurs mesurées et paramétriques sont mise en mémoire, et en ce que ladite technique paramétrique est réalisée sur de telles valeurs déjà mémorisées.

Abb. 1

EP 0 471 698 B1

Abb. 2

Abb. 3

EP 0 471 698 B1

Abb. 4

Abb. 5

EP 0 471 698 B1